# EUROPEAN PATENT APPLICATION

(11) **EP 4 362 099 A1**
(43) Date of publication of application: **01.05.2024**
(21) Application number: 22828029.3
(22) Date of filing: 30.03.2022
(51) Int. Cl.: H01L 27/146, H04N 5/374

(54) **IMAGING DEVICE AND ELECTRONIC APPARATUS**

(30) Priority: 25.06.2021 JP 2021105906
(71) Applicant: Sony Semiconductor Solutions Corporation, Atsugi-shi, Kanagawa 243-0014 (JP)
(72) Inventor: ONO, Mizuki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/015788
(87) International publication number: WO 2022/270110

(57) **Abstract**

[Object]

Provided are an imaging device capable of preventing a decrease in quantum efficiency, and an electronic apparatus using this imaging device.

[Solving Means]

The imaging device of the present disclosure includes multiple photoelectric conversion sections provided for respective pixels and each having a first end portion on a light incident side and a second end portion on a side opposite to the first end portion, a first member disposed along a boundary of each of the multiple photoelectric conversion sections in a first direction that extends from the first end portion to the second end portion, and a second member provided between each of the multiple photoelectric conversion sections and the first member and at the first end portion, the second member containing a material with a lower refractive index than that of the photoelectric conversion sections.

## Description

### [Technical Field]

Embodiments of the present disclosure relate to an imaging device and an electronic apparatus.

### [Background Art]

An imaging device has been known in which an electrode is embedded within a trench for separating a photoelectric conversion layer into multiple pixels (PTL 1). In this imaging device, a negative bias voltage is applied to the above-mentioned electrode to collect holes generated in the photoelectric conversion layer when light is received, thereby preventing dark current and the generation of white spots in captured images.

### [Citation List]

### [Patent Literature]

[PTL 1]
WO 2018/150902

### [Summary]

### [Technical Problem]

However, in the imaging device described in PTL 1, in a case where polycrystalline silicon is used for the above-mentioned electrode, light absorption by the polycrystalline silicon occurs, leading to a decrease in quantum efficiency, which is a problem.

The present disclosure provides an imaging device capable of preventing a decrease in quantum efficiency, and an electronic apparatus using this imaging device.

### [Solution to Problem]

An imaging device according to a first aspect of the present disclosure includes multiple photoelectric conversion sections provided for respective pixels and each having a first end portion on a light incident side and a second end portion on a side opposite to the first end portion, a first member disposed along a boundary of each of the multiple photoelectric conversion sections in a first direction that extends from the first end portion to the second end portion, and a second member provided between each of the multiple photoelectric conversion sections and the first member and on a side of the first end portion, the second member containing a material with a lower refractive index than that of the photoelectric conversion sections.

In the imaging device according to the first aspect, the second member may include a conductor.

In the imaging device according to the first aspect, the second member may include sealed air.

In the imaging device according to the first aspect, a thickness of the second member may decrease along the first direction.

The imaging device according to the first aspect may further include, in a region other than a region in which the second member is disposed in each of the photoelectric conversion sections, a semiconductor layer of a different conductivity type from that of the photoelectric conversion sections.

In the imaging device according to the first aspect, the second member may extend along the first direction to a side of the second end portion, and a sum of a thickness of the first member and a thickness of the second member may be constant along the first direction.

In the imaging device according to the first aspect, a thickness on the side of the first end portion of the second member may be smaller than a thickness on the side of the second end portion thereof.

In the imaging device according to the first aspect, the multiple photoelectric conversion sections may each have a first portion and a second portion, and, in plan view, the first portion and the second portion may be surrounded by the first member at a boundary therebetween, except for certain portions of central portions of the first portion and the second portion, and may be in contact with each other at the certain portions.

In the imaging device according to the first aspect, the multiple photoelectric conversion sections may each have a substantially rectangular shape in plan view, and a thickness at a corner portion of the substantially rectangular shape of the second member may be larger than a thickness at another portion thereof.

In the imaging device according to the first aspect, a thickness of the second member may be 20 nm or more, and a length in a depth direction of the second member may be 1,000 nm or more.

In the imaging device according to the first aspect, the second member may be disposed to surround each of the multiple photoelectric conversion sections.

In the imaging device according to the first aspect, the first member may contain polysilicon.

The imaging device according to the first aspect may further include a micro lens provided correspondingly to each of the multiple photoelectric conversion sections.

The imaging device according to the first aspect may further include a color filter provided between each of the multiple photoelectric conversion sections and the micro lens.

In the imaging device according to the first aspect, the multiple photoelectric conversion sections may be divided into groups arranged in an array, and the imaging device may further include a micro lens provided correspondingly to each of the groups.

The imaging device according to the first aspect may further include a circuit disposed on a side of the second end portion and including a pixel transistor.

In the imaging device according to the first aspect, the multiple photoelectric conversion sections may each contain silicon, and the second member may contain silicon oxide.

An electronic apparatus according to a second aspect includes an imaging device, and a signal processing unit configured to perform signal processing based on a pixel signal captured by the imaging device, the imaging device including multiple photoelectric conversion sections provided for respective pixels and each having a first end portion on a light incident side and a second end portion on a side opposite to the first end portion, a first member disposed along a boundary of each of the multiple photoelectric conversion sections in a first direction that extends from the first end portion to the second end portion, and a second member provided between each of the multiple photoelectric conversion sections and the first member and on a side of the first end portion, the second member containing a material with a lower refractive index than that of the photoelectric conversion sections.

### [Brief Description of Drawings]

[FIG. 1]

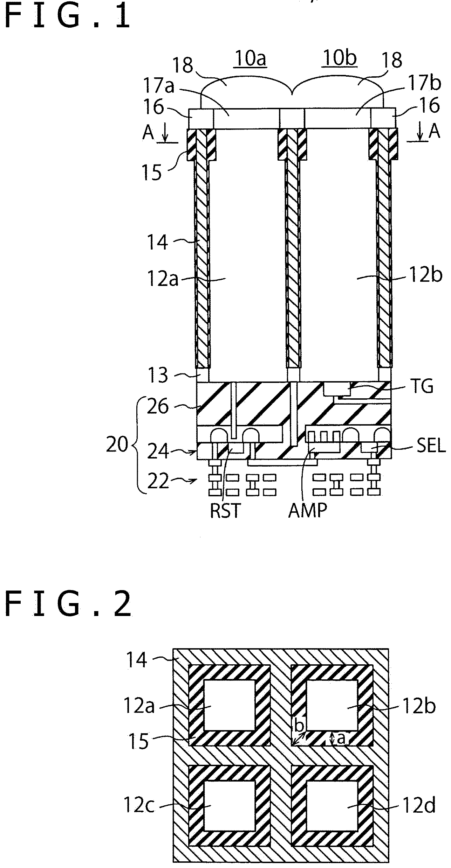

   FIG. 1 is a sectional view depicting an imaging device according to a first embodiment.
[FIG. 2]
   FIG. 2 is a sectional view taken along a cutting plane line A-A depicted in FIG. 1.
[FIG. 3]

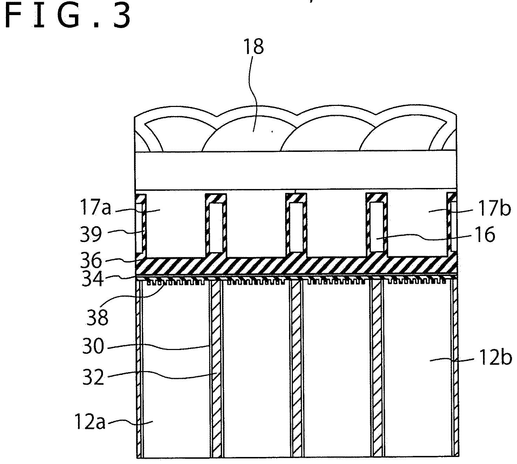

   FIG. 3 is a sectional view depicting an imaging device used as a sample in simulations.
[FIG. 4]

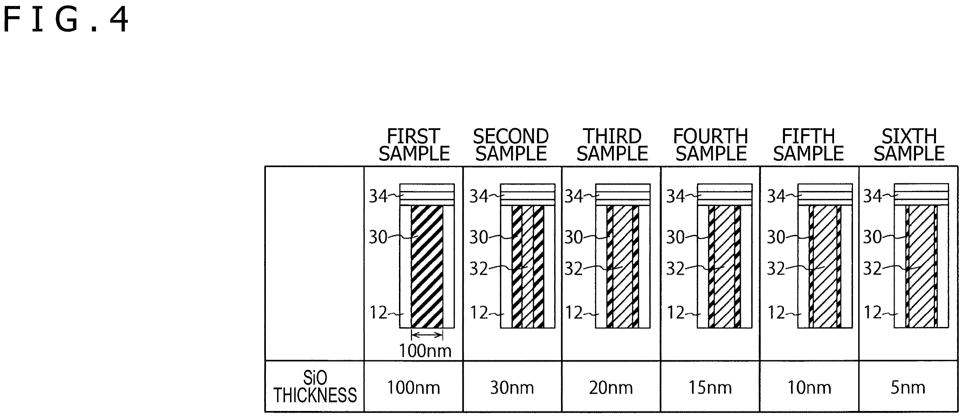

   FIG. 4 is a diagram depicting first to sixth samples obtained by changing the thickness of a light absorption inhibition section of the sample depicted in FIG. 3.
[FIG. 5]

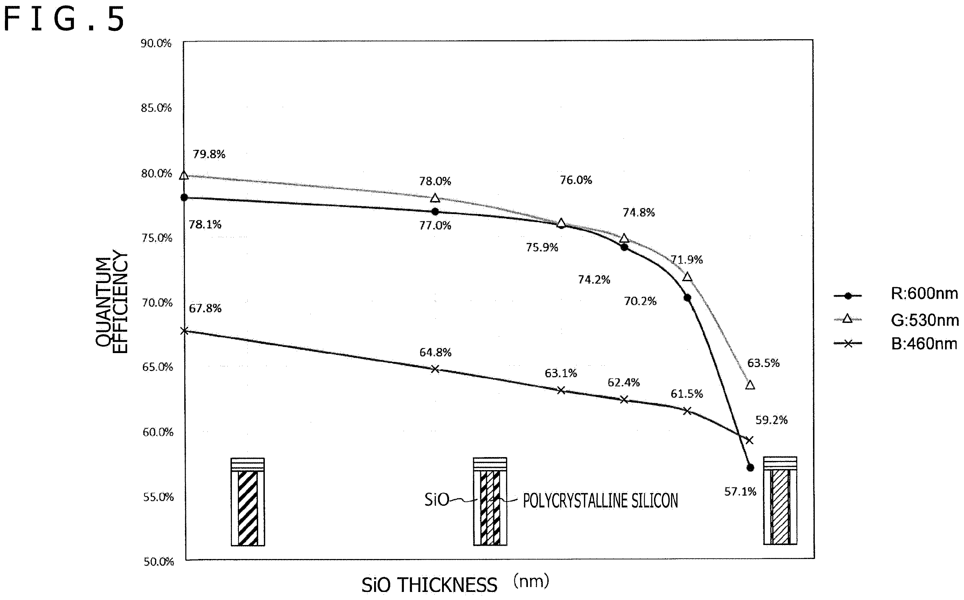

   FIG. 5 is a graph depicting the results of simulations for determining the quantum efficiency for red light, green light, and blue light of the first to sixth samples depicted in FIG. 4.
[FIG. 6]

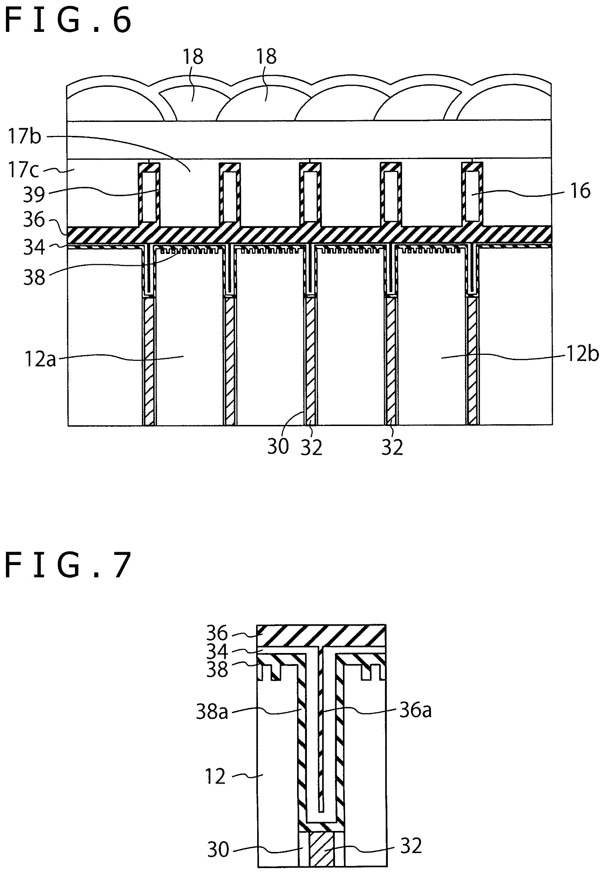

   FIG. 6 is a sectional view depicting an imaging device used as a sample in simulations.
[FIG. 7]
   FIG. 7 is a sectional view depicting a light absorption inhibition section of the imaging device depicted in FIG. 6.
[FIG. 8]

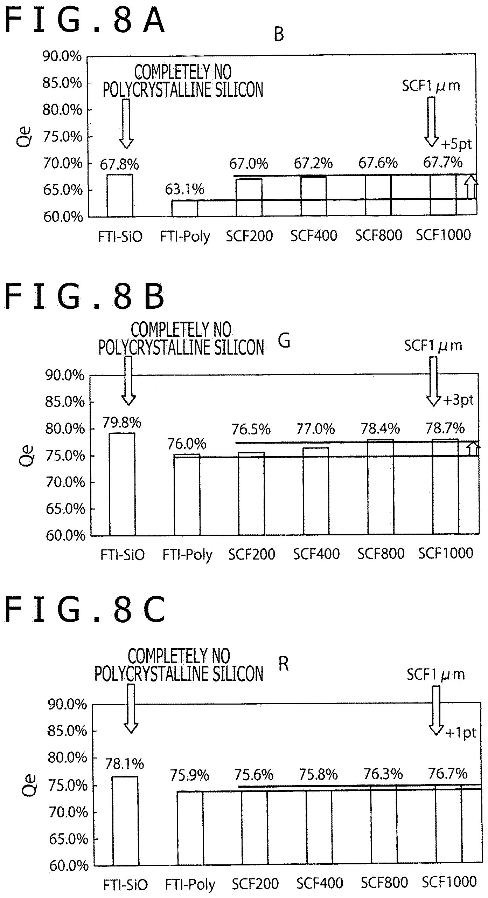

   FIG. 8A to FIG. 8C are diagrams depicting quantum effects in a case where the length in the depth direction of the light absorption inhibition section is changed.
[FIG. 9]

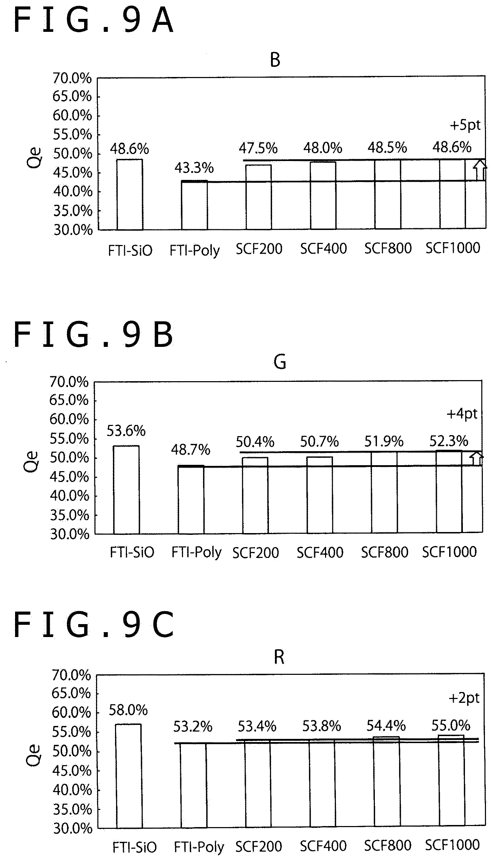

   FIG. 9A to FIG. 9C are diagrams depicting quantum effects in a case where the length in the depth direction of the light absorption inhibition section is changed.
[FIG. 10]

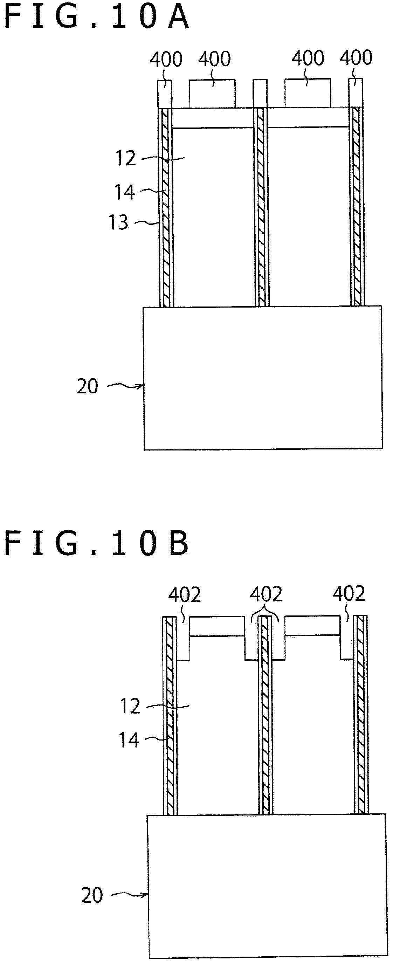

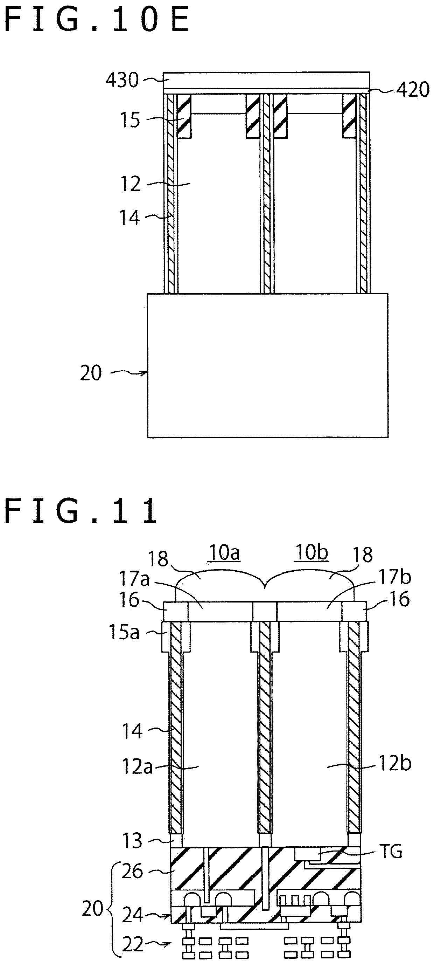

   FIG. 10A to FIG. 10E are sectional views depicting the manufacturing processes of the light absorption inhibition section in the imaging device of the first embodiment.
[FIG. 11]
   FIG. 11 is a sectional view depicting an imaging device according to a second embodiment.
[FIG. 12]

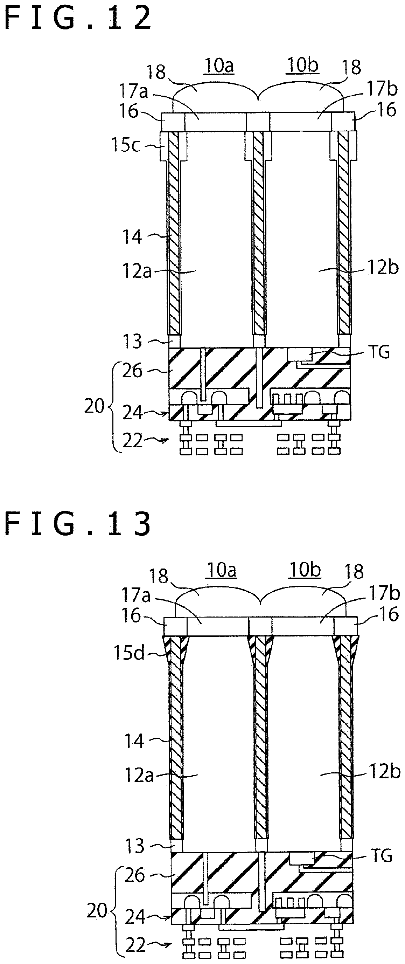

   FIG. 12 is a sectional view depicting an imaging device according to a third embodiment.
[FIG. 13]
   FIG. 13 is a sectional view depicting an imaging device according to a fourth embodiment.
[FIG. 14]

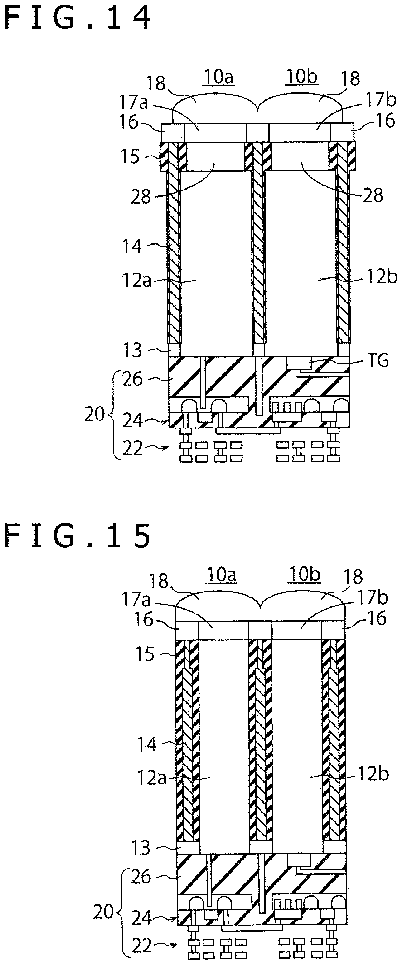

   FIG. 14 is a sectional view depicting an imaging device according to a fifth embodiment.
[FIG. 15]
   FIG. 15 is a sectional view depicting an imaging device according to a sixth embodiment.
[FIG. 16A]

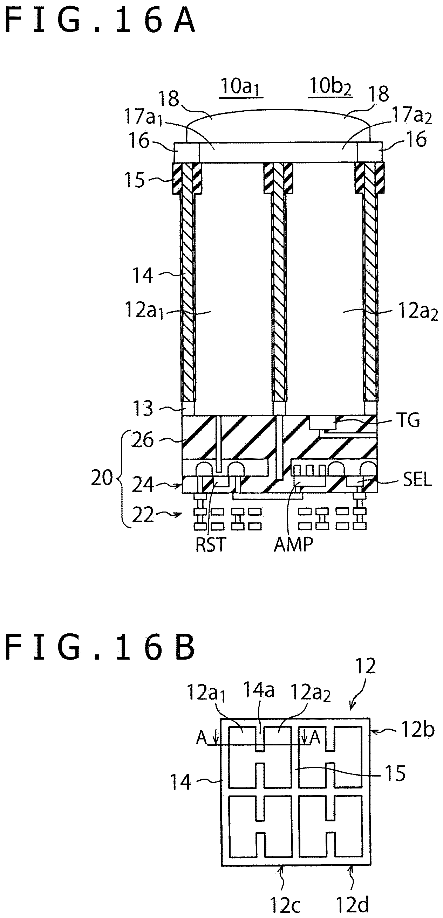

   FIG. 16A is a sectional view of an imaging device according to a seventh embodiment.
[FIG. 16B]
   FIG. 16B is a plan view of a single pixel group in the imaging device of the seventh embodiment.
[FIG. 17]

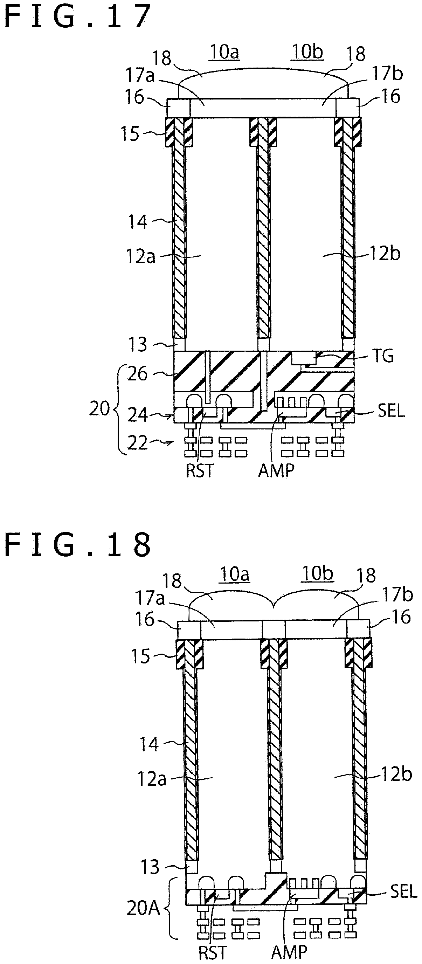

   FIG. 17 is a sectional view depicting an imaging device according to an eighth embodiment.
[FIG. 18]
   FIG. 18 is a sectional view depicting an imaging device according to a ninth embodiment.
[FIG. 19]

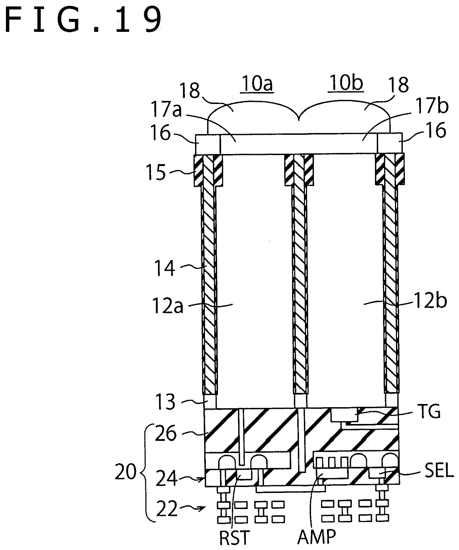

   FIG. 19 is a sectional view depicting an imaging device according to a tenth embodiment.
[FIG. 20]

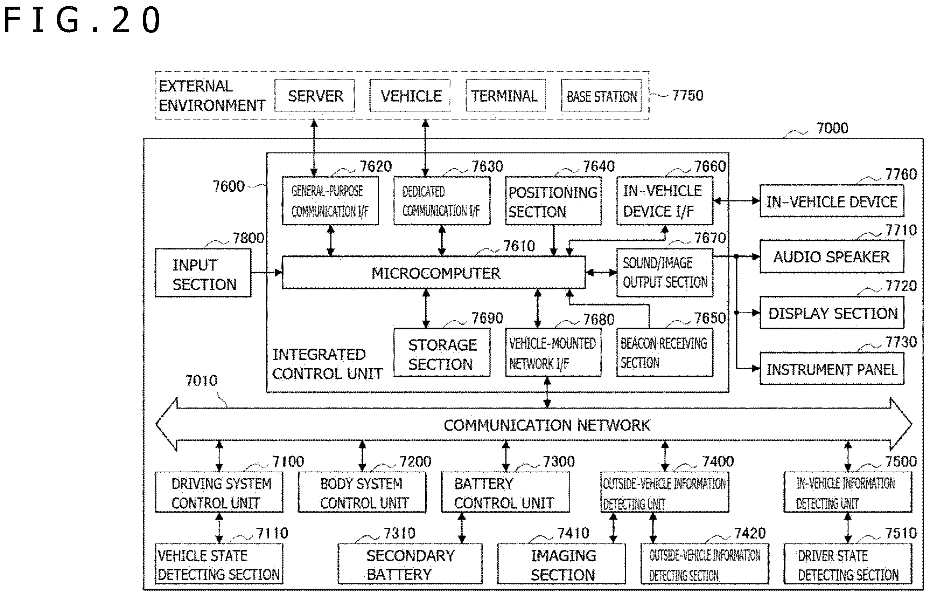

   FIG. 20 is a block diagram depicting an example of schematic configuration of a vehicle control system.
[FIG. 21]

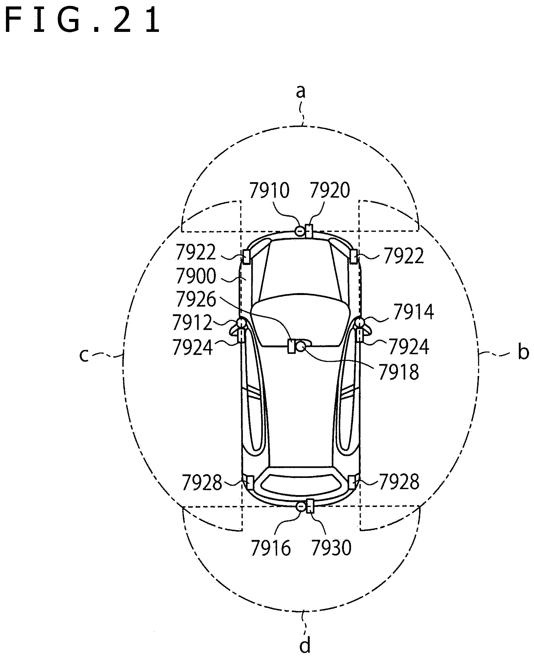

   FIG. 21 is a diagram of assistance in explaining an example of installation positions of an outside-vehicle information detecting section and an imaging section.

### [Description of Embodiments]

Referring to the drawings, embodiments of the present disclosure are described. In the following embodiments, although components of an imaging device and an electronic apparatus are mainly described, the imaging device and the electronic apparatus may include or have undepicted or undescribed components or functions. The following description does not exclude the undepicted or undescribed components or functions.

Further, the figures referred to in the following description are figures for describing the embodiments of the present disclosure and promoting understanding thereof. For the purpose of clarity, shapes, dimensions, ratios, and the like depicted in the figures may be different from the actual ones.

### (First Embodiment)

An imaging device according to a first embodiment is described with reference to FIG. 1 and FIG. 2. FIG. 1 is a sectional view of the imaging device according to the first embodiment, and FIG. 2 is a sectional view taken along a cutting plane line A-A depicted in FIG. 1. This imaging device of the first embodiment includes at least a single pixel group, and this pixel group includes four pixels 10a, 10b, 10c, and 10d disposed in two rows and two columns. Each pixel includes a photoelectric conversion section. For example, the pixel 10a includes a photoelectric conversion section 12a, the pixel 10b includes a photoelectric conversion section 12b, the pixel 10c includes a photoelectric conversion section 12c, and the pixel 10d includes a photoelectric conversion section 12d. These photoelectric conversion sections 12a, 12b, 12c, and 12d are isolated from each other by a trench 13 formed in a photoelectric conversion layer 12. That is, the trench 13 is formed to surround each of the photoelectric conversion sections 12a, 12b, 12c, and 12d. Then, within each portion of the trench 13, a conductor (first member) 14 is embedded. In the present embodiment, as the conductor 14, polycrystalline silicon is used, for example. A negative bias potential is applied to the conductor 14. By applying a negative bias potential to the conductor 14 to collect holes generated during light reception in the conductor 14, dark current and the generation of white spots in captured images can be prevented.

Above each of the photoelectric conversion sections 12a, 12b, 12c, and 12d, a micro lens 18 is provided. Between each of the photoelectric conversion sections 12a, 12b, 12c, and 12d and the corresponding micro lens 18, a color filter is provided. For example, a color filter 17a is provided between the photoelectric conversion section 12a and the micro lens 18, and a color filter 17b is provided between the photoelectric conversion section 12b and the micro lens 18. An inter-pixel light shielding section 16 is provided to surround these color filters. The inter-pixel light shielding section 16 is disposed on the conductor 14 embedded within the trench 13.

As depicted in FIG. 1, in each of the photoelectric conversion sections 12a, 12b, 12c, and 12d, a light absorption inhibition section (second member) 15 is provided at the upper end portion on the color filter side. As depicted in FIG. 2, the light absorption inhibition section 15 is formed to surround each of the photoelectric conversion sections 12a, 12b, 12c, and 12d. Then, as depicted in FIG. 2, a thickness b at the corner portion of the photoelectric conversion section of the light absorption inhibition section 15 is larger than a thickness a at other portions thereof. As the light absorption inhibition section 15, a material with a lower refractive index than a material contained in the photoelectric conversion sections 12a, 12b, 12c, and 12d is used. For example, when the photoelectric conversion sections 12a, 12b, 12c, and 12d contain, for example, silicon, silicon oxide (SiO) is used as the light absorption inhibition section 15, for example.

At the lower end portion (the end portion on the side opposite to the micro lens 18) of the pixel group, pixel transistors for reading out signals from the pixel group and a circuit 20 configured to drive the pixel transistors are provided. The circuit 20 has a three-stage structure including a first stage section 26 including a transfer gate TG connected to the photoelectric conversion sections 12a, 12b, 12c, and 12d, a second stage section 24 on which pixel transistors such as a reset transistor RST, an amplification transistor AMP, and a selection transistor SEL are disposed, and a stacked wiring section 22 with stacked wiring lines.

As described above, in the imaging device of the present embodiment, the conductor 14 containing, for example, polycrystalline silicon, is provided within the trench 13 for separating the pixels 10a, 10b, 10c, and 10d from each other. The light absorption inhibition section 15 is provided between the conductor 14 and each of the photoelectric conversion sections 12a, 12b, 12c, and 12d. Then, the light absorption inhibition section 15 is provided at the upper end portion on the color filter side in each of the photoelectric conversion sections 12a, 12b, 12c, and 12d. As the light absorption inhibition section 15, a material with a lower refractive index than a material contained in the photoelectric conversion sections 12a, 12b, 12c, and 12d is used. This makes it possible to prevent the leakage of evanescent light, which is a major factor for the absorption of light generated in the photoelectric conversion layer 12 into the conductor 14 containing polycrystalline silicon during light reception, thereby preventing a decrease in quantum efficiency. Note that, in the present specification, the photoelectric conversion section is provided for each pixel, and the photoelectric conversion layer 12 is a semiconductor layer including all the photoelectric conversion sections.

Next, an appropriate thickness of the light absorption inhibition section 15 was determined using simulations in the imaging device of the first embodiment. A cross section of an imaging device used in the simulations is depicted in FIG. 3. The imaging device depicted in FIG. 3 includes the photoelectric conversion sections 12a and 12b separated from each other by a trench filled with silicon oxide (SiO) 30. The silicon oxide 30 is disposed to cover polycrystalline silicon 32, and the thickness of the silicon oxide 30 within the trench is adjusted by the thickness of the polycrystalline silicon 32. A fixed charge film 34 and an oxide film 36 disposed on the fixed charge film 34 are provided on each of the photoelectric conversion layers 12. Further, an uneven structure 38 for preventing reflection of light is provided on the light incident surface of the semiconductor substrate.

Correspondingly to the respective photoelectric conversion sections 12a and 12b, the color filters 17a and 17b are disposed on the oxide film 36. The color filter 17a is, for example, a green filter, and the color filter 17b is a red filter. Note that, although not depicted in FIG. 3, there is also a blue filter as a color filter. These color filters are separated from each other by a low refractive index waveguide 39. That is, the low refractive index waveguide 39 optically separates the color filters from each other and is located on the trench and used to detect light that has leaked from the polycrystalline silicon 32 into the silicon oxide 30 disposed within the trench. The micro lens 18 is provided on each of the color filters 17a and 17b correspondingly to each photoelectric conversion section.

Regarding the imaging device having such a structure, samples obtained by adjusting the thickness of the silicon oxide 30 within the trench by the thickness of the polycrystalline silicon 32 are depicted in FIG. 4. First to sixth samples each having a trench with a width of 100 nm were prepared. The first sample included the silicon oxide 30 with a thickness of 100 nm and the polycrystalline silicon 32 with a thickness of 0 nm within the trench. The second sample included the silicon oxide 30 with a thickness of 30 nm and the polycrystalline silicon 32 with a thickness of 40 nm within the trench. The third sample included the silicon oxide 30 with a thickness of 20 nm and the polycrystalline silicon 32 with a thickness of 60 nm within the trench. The fourth sample included the silicon oxide 30 with a thickness of 15 nm and the polycrystalline silicon 32 with a thickness of 70 nm within the trench. The fifth sample included the silicon oxide 30 with a thickness of 10 nm and the polycrystalline silicon 32 with a thickness of 80 nm within the trench. The sixth sample included the silicon oxide 30 with a thickness of 5 nm and the polycrystalline silicon 32 with a thickness of 90 nm within the trench.

The first to sixth samples were simulated to determine quantum efficiency Qe (the ratio of photons converted into electrons, which can be extracted as electrical signals, to photons incident on the imaging device). The results are depicted in FIG. 5. In the simulations, calculations were performed with red light at a wavelength of 600 nm, green light at a wavelength of 530 nm, and blue light at a wavelength of 460 nm. In the case of green light and red light incidence on the imaging device, the quantum efficiency Qe linearly decreases as the thickness of the silicon oxide 30 decreases, and the quantum efficiency Qe non-linearly decreases when the thickness of the silicon oxide 30 falls below 20 nm. In the case of blue light incidence on the imaging device, the quantum efficiency is lower than that in the case of red light or green light incidence. In the case of blue light incidence on the imaging device, the quantum efficiency Qe linearly decreases as the thickness of the silicon oxide 30 decreases down to 10 nm, and the quantum efficiency Qe non-linearly decreases when the thickness of the silicon oxide 30 falls below 10 nm. From the above, in the imaging device depicted in FIG. 4, when the thickness of the silicon oxide falls below 20 nm, the leakage of evanescent light increases. Thus, when the thickness of the silicon oxide 30, that is, the thickness of the light absorption inhibition section 15, is set to 20 nm or more, it is possible to prevent the leakage of evanescent light, thereby preventing a decrease in quantum efficiency.

Next, an appropriate length in the depth direction of the light absorption inhibition section 15 was determined using simulations in the imaging device of the first embodiment. A cross section of an imaging device used in the simulations is depicted in FIG. 6. The imaging device depicted in FIG. 6 has a configuration corresponding to the imaging device depicted in FIG. 3 in which a portion of the polycrystalline silicon within the trench is replaced by the fixed charge film 34. The configuration obtained by replacing, within the trench, a portion of the polycrystalline silicon by the fixed charge film 34 is depicted in FIG. 7. Along the side surfaces of the trench, an oxide member 38a of the same material as the uneven structure 38 is disposed, and the fixed charge film 34 is disposed along the side surfaces and bottom surface of the oxide member 38a. An oxide film 36b that reaches the bottom portion of the fixed charge film 34 is disposed at the central portion of the fixed charge film 34.

First to sixth samples are prepared as subjects to be simulated. The first sample is an imaging device whose trench is completely filled with silicon oxide (hereinafter also referred to as "FTI-SiO"), the second sample is an imaging device whose trench is completely filled with polycrystalline silicon (hereinafter also referred to as "FTI-Poly"), the third sample is an imaging device in which the depth of the fixed charge film 34 within the trench is 200 nm (hereinafter also referred to as "SCF200"), the fourth sample is an imaging device in which the depth of the fixed charge film 34 within the trench is 400 nm, the fifth sample is an imaging device in which the depth of the fixed charge film 34 within the trench is 800 nm (hereinafter also referred to as "SCF800"), and the sixth sample is an imaging device in which the depth of the fixed charge film 34 within the trench is 1,000 nm (hereinafter also referred to as "SCF1000"). That is, the first sample is an imaging device with almost no evanescent light leakage, the second sample is an imaging device with the largest evanescent light leakage, and the third to sixth samples are imaging devices with evanescent light leakage positioned between the first sample and the second sample.

The results of determining the quantum efficiency Qe in a case where blue light is emitted on the first to sixth samples at an incident angle of 0 degrees are depicted in FIG. 8A. The sixth sample can obtain almost the same quantum efficiency as the first sample and obtain a quantum efficiency approximately 5% higher than that of the second sample. The quantum efficiency Qe is higher in the order of the second sample, the third sample, the fourth sample, the fifth sample, and the sixth sample.

The results of determining the quantum efficiency Qe in a case where green light is emitted on the first to sixth samples at an incident angle of 0 degrees are depicted in FIG. 8B. The sixth sample exhibits a quantum efficiency 1.5% lower than that of the first sample but can obtain a quantum efficiency approximately 3% higher than that of the second sample. The quantum efficiency Qe is higher in the order of the second sample, the third sample, the fourth sample, the fifth sample, and the sixth sample.

The results of determining the quantum efficiency Qe in a case where red light is emitted on the first to sixth samples at an incident angle of 0 degrees are depicted in FIG. 8C. The sixth sample exhibits a quantum efficiency 1.4% lower than that of the first sample but can obtain a quantum efficiency approximately 1% higher than that of the second sample. The quantum efficiency Qe is higher in the order of the second sample, the third sample, the fourth sample, the fifth sample, and the sixth sample.

The results of determining the quantum efficiency Qe in a case where blue light is emitted on the first to sixth samples at an incident angle of 36 degrees are depicted in FIG. 9A. The sixth sample can obtain almost the same quantum efficiency as the first sample and obtain a quantum efficiency approximately 5% higher than that of the second sample. The quantum efficiency Qe is higher in the order of the second sample, the third sample, the fourth sample, the fifth sample, and the sixth sample.

The results of determining the quantum efficiency Qe in a case where green light is emitted on the first to sixth samples at an incident angle of 36 degrees are depicted in FIG. 9B. The sixth sample exhibits a quantum efficiency 1.3% lower than that of the first sample but can obtain a quantum efficiency approximately 4% higher than that of the second sample. The quantum efficiency Qe is higher in the order of the second sample, the third sample, the fourth sample, the fifth sample, and the sixth sample.

The results of determining the quantum efficiency Qe in a case where red light is emitted on the first to sixth samples at an incident angle of 0 degrees are depicted in FIG. 9C. The sixth sample exhibits a quantum efficiency 3% lower than that of the first sample but can obtain a quantum efficiency approximately 2% higher than that of the second sample. The quantum efficiency Qe is higher in the order of the second sample, the third sample, the fourth sample, the fifth sample, and the sixth sample.

As can be seen from FIG. 8A and FIG. 9A, in the case of blue light, the quantum efficiency is significantly improved when the length in the depth direction of the fixed charge film 34 is 200 nm, and the quantum efficiency slightly increases when the length in the depth direction of the fixed charge film 34 is equal to or more than this length. As can be seen from FIG. 8B and FIG. 9B, in the case of green light, the sixth sample achieves a quantum efficiency improvement of 2.4% to 3.2% when the length in the depth direction of the fixed charge film 34 is 800 nm and achieves a quantum efficiency improvement of 3% to approximately 4% when the length in the depth direction of the fixed charge film 34 is 100 nm, as compared to the second sample. As can be seen from FIG. 8C and FIG. 9C, in the case of red light, the quantum efficiency slightly increases as the length in the depth direction of the fixed charge film 34 increases.

As can be seen from FIG. 8A to FIG. 9C, in the case of red light, the quantum efficiency slightly increases even when the length in the depth direction of the fixed charge film 34 increases. However, in the case of green light and blue light, as the length in the depth direction of the fixed charge film 34 increases, the quantum efficiency increases, and when the length in the depth direction of the fixed charge film 34 is 1,000 nm (1 µm), a quantum efficiency close to that of the first sample, which has almost no evanescent light leakage, is achieved, and an effect of inhibiting light absorption can therefore be obtained.

Next, the manufacturing method of the light absorption inhibition section 15 of the imaging device of the first embodiment is described with reference to FIG. 10A to FIG. 10E. First, as depicted in FIG. 10A, the photoelectric conversion layer 12 is formed on pixel transistors and the circuit 20 configured to drive the pixel transistors. A trench for separating and optically isolating pixels is formed in the photoelectric conversion layer 12, and the conductor 14 is embedded within this trench. This allows the photoelectric conversion layer 12 to serve as the photoelectric conversion section 12. Subsequently, a mask 400 is formed on the photoelectric conversion section 12 and the conductor 14 (see FIG. 10A).

Next, using the mask 400, the photoelectric conversion section 12 is dry-etched, for example, is subjected to RIE (Reactive Ion Etching), thereby etching the photoelectric conversion section 12 by 1 µm in the depth direction, for example. A region 402 obtained by removing the photoelectric conversion section 12 by etching serves as a region in which the light absorption inhibition section 15 is provided. After that, the mask 400 is removed (see FIG. 10B).

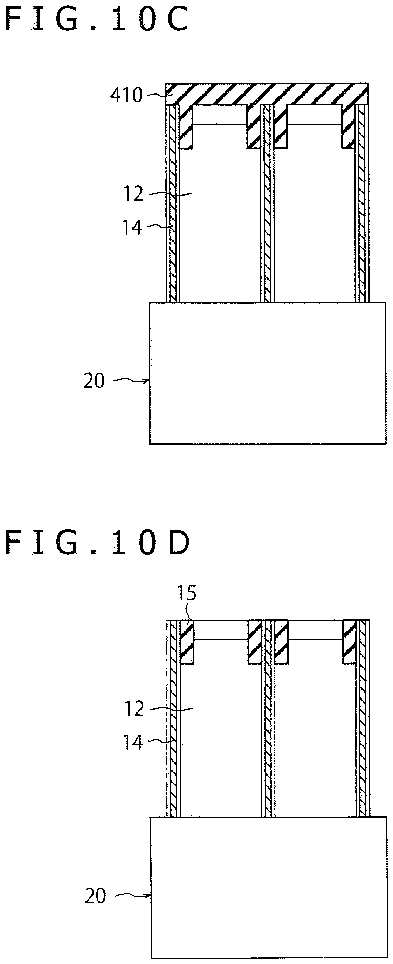

Next, for example, silicon oxide 410 is deposited to be embedded in the region 402 (see FIG. 10C). Subsequently, the surface of the silicon oxide 410 is planarized using CMP (Chemical Mechanical Etching) to expose the surface of the photoelectric conversion section 12 (see FIG. 10D). With this, the light absorption inhibition section 15 including silicon oxide is formed. After that, a fixed charge film 420 is deposited, and an oxide film 430 is formed on the fixed charge film 420.

As described above, according to the first embodiment, the imaging device capable of preventing a decrease in quantum efficiency can be provided.

### (Second Embodiment)

An imaging device according to a second embodiment is depicted in FIG. 11. This imaging device of the second embodiment has a configuration corresponding to the imaging device depicted in FIG. 1 in which a material with a lower refractive index than the material of the photoelectric conversion section is used as the material of the light absorption inhibition section 15, instead of silicon oxide (SiO). For example, when the photoelectric conversion sections 12a and 12b are semiconductors containing silicon, a material with a lower refractive index than silicon is used for the light absorption inhibition section 15. When the photoelectric conversion sections 12a and 12b include a compound semiconductor, a material with a lower refractive index than this compound semiconductor is used. With such a configuration, it is possible to increase the reflectance, thereby inhibiting the absorption of light by the polycrystalline silicon. The imaging device of the second embodiment can also prevent a decrease in quantum efficiency, similar to the first embodiment.

### (Third Embodiment)

An imaging device according to a third embodiment is depicted in FIG. 12. This imaging device of the third embodiment has a configuration corresponding to the imaging device depicted in FIG. 1 in which air is sealed in the light absorption inhibition section 15 instead of silicon oxide. Since air has a lower refractive index than silicon, the imaging device of the third embodiment can also prevent a decrease in quantum efficiency, similar to the first embodiment.

### (Fourth Embodiment)

An imaging device according to a fourth embodiment is depicted in FIG. 13. This imaging device of the fourth embodiment has a configuration corresponding to the imaging device depicted in FIG. 1 in which the thickness of the light absorption inhibition section 15 decreases along the depth direction. With this, the thickness in the depth direction of the light absorption inhibition section decreases, thereby making it possible to expand the region for the application of an electric field from the conductor 14 to the photoelectric conversion section 12. The generation of white spots in captured images is prevented by the thick light absorption inhibition section 15 in the shallow portion in which the leakage of evanescent light is strong, and in the deep portion, the generation of white spots in captured images is prevented by applying a negative bias to the conductor 14. The imaging device of the fourth embodiment can also prevent a decrease in quantum efficiency, similar to the first embodiment.

### (Fifth Embodiment)

An imaging device according to a fifth embodiment is depicted in FIG. 14. This imaging device of the fifth embodiment has a configuration corresponding to the imaging device depicted in FIG. 1 in which the region of the upper end portion of each of the photoelectric conversion sections 12a and 12b surrounded by the light absorption inhibition section 15 serves as a semiconductor layer 28 of a conductivity type different from the conductivity type of the photoelectric conversion sections 12a and 12b. Since the region surrounded by the light absorption inhibition section 15 is not affected by a negative bias applied to the conductor 14, by providing the semiconductor layer 28 of a different conductivity type from that of the photoelectric conversion sections 12a and 12b, the generation of white spots in captured images can be prevented. The imaging device of the fifth embodiment can also prevent a decrease in quantum efficiency, similar to the first embodiment.

### (Sixth Embodiment)

An imaging device according to a sixth embodiment is depicted in FIG. 15. This imaging device of the sixth embodiment based on the imaging device depicted in FIG. 1 is configured such that the light absorption inhibition section 15 is provided not only at the upper end portion of each of the photoelectric conversion sections 12a and 12b, but also along the depth direction to the lower end portion thereof, and that the sum of the thickness of the conductor 14 and the thickness of the light absorption inhibition section 15 is substantially constant. Thus, the light absorption inhibition section 15 is thick at the upper end portion of each of the photoelectric conversion sections 12a and 12b and thin at the lower end portion thereof. Since the thickness at the upper end portion of the photoelectric conversion section, at which the leakage of evanescent light is strong, of the light absorption inhibition section 15 is larger than that at other portions thereof, a decrease in quantum efficiency can be prevented, similar to the first embodiment. Note that, in the present embodiment, the thickness of the photoelectric conversion sections 12a and 12b (the length in the horizontal direction on FIG. 15) is substantially constant.

### (Seventh Embodiment)

An imaging device according to a seventh embodiment is described with reference to FIG. 16A and FIG. 16B. FIG. 16A is a sectional view taken along a cutting plane line A-A depicted in FIG. 16B, and FIG. 16B is a plan view of a single pixel group.

In this imaging device of the seventh embodiment based on the imaging device depicted in FIG. 1, in the pixel group including the four pixels 10a, 10b, 10c, and 10d, the photoelectric conversion section of each pixel, for example, the photoelectric conversion section 12a of the pixel 10a is divided into two photoelectric conversion sections 12a₁ and 12a₂, and the two photoelectric conversion sections 12a₁ and 12a₂ after division are separated by a conductor 14a embedded in a trench. As can be seen from FIG. 16B, the photoelectric conversion sections 12a₁ and 12a₂ are separated by the conductor 14a provided within the trench. The conductor 14a is cut at its central portion in plan view to allow the photoelectric conversion section 12a₁ to be connected to the photoelectric conversion section 12a₂ at this cut point. The side portions of the conductor 14a are surrounded by the light absorption inhibition section 15 at the upper end portion of each of the photoelectric conversion sections 12a₁ and 12a₂. Note that the micro lens 18 is shared by the two photoelectric conversion sections 12a₁ and 12a₂.

In the seventh embodiment configured in such a way, with the photoelectric conversion section of each pixel divided into the two photoelectric conversion sections, the phase difference of images can be detected. The imaging device of the seventh embodiment can also prevent a decrease in quantum efficiency, similar to the first embodiment.

### (Eighth Embodiment)

An imaging device according to an eighth embodiment is depicted in FIG. 17. In the imaging device depicted in FIG. 1, each pixel forming the single pixel group is provided with the micro lens 18. However, in the configuration of the eighth embodiment, a single micro lens is provided for a single pixel group. Except for the micro lens 18, the configuration is similar to that of the first embodiment. The imaging device of the eighth embodiment can also prevent a decrease in quantum efficiency, similar to the first embodiment.

### (Ninth Embodiment)

An imaging device according to a ninth embodiment is depicted in FIG. 18. In the imaging device depicted in FIG. 1, the pixel transistors and the circuit 20 configured to drive the pixel transistors are provided for the single pixel group, and this circuit has the three-stage structure. The imaging device of the ninth embodiment has a configuration in which pixel transistors such as the reset transistor RST, the amplification transistor AMP, and the selection transistor SEL are disposed in the same layer. Except for this, the configuration is the same as that of the imaging device of the first embodiment. The imaging device of the ninth embodiment can also prevent a decrease in quantum efficiency, similar to the first embodiment.

### (Tenth Embodiment)

An imaging device according to a tenth embodiment is depicted in FIG. 19. In the imaging device depicted in FIG. 1, the conductor 14 contains, for example, polycrystalline silicon. In the imaging device of the tenth embodiment, as the conductor 14, a conductive metal material with a lower refractive index than a material contained in the photoelectric conversion section, such as tantalum oxide or tungsten, is used. The imaging device of the tenth embodiment can also prevent a decrease in quantum efficiency, similar to the first embodiment.

### (Application Example)

The technology according to the present disclosure is applicable to various products. For example, the technology according to the present disclosure may be implemented as a device that is mounted on any kind of mobile bodies such as vehicles, electric vehicles, hybrid electric vehicles, motorcycles, bicycles, personal mobilities, airplanes, drones, ships, robots, construction machinery, and agricultural machinery (tractors).

FIG. 20 is a block diagram depicting an example of schematic configuration of a vehicle control system 7000 as an example of a mobile body control system to which the technology according to an embodiment of the present disclosure can be applied. The vehicle control system 7000 includes a plurality of electronic control units connected to each other via a communication network 7010. In the example depicted in FIG. 19, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. A functional configuration of the integrated control unit 7600 illustrated in FIG. 20 includes a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

FIG. 21 depicts an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Incidentally, FIG. 21 depicts an example of photographing ranges of the respective imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Returning to FIG. 20, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magnetooptical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example of FIG. 20, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Incidentally, at least two control units connected to each other via the communication network 7010 in the example depicted in FIG. 20 may be integrated into one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

Note that the imaging device of any one of the first to tenth embodiments can be used as the imaging section 7410 depicted in FIG. 20 or the imaging sections 7910 to 7916 depicted in FIG. 21.

Although the embodiments of the present disclosure have been described in detail above with reference to the accompanying drawings, the technical scope of the present disclosure is not limited to the examples. It is apparent that those ordinarily skilled in the technical field of the present disclosure may conceive various alterations or modifications within the scope of the technical idea described in Claims. It is to be understood that these naturally come under the technical scope of the present disclosure.

Further, the effects described herein are merely explanatory or exemplary and are not limitative. That is, the technology according to the present disclosure may achieve other effects that are apparent to those skilled in the art from the description of this specification, either in addition to or in place of the above-mentioned effects.

Note that the following configurations also belong to the technical scope of the present disclosure.
(1) An imaging device including:
   multiple photoelectric conversion sections provided for respective pixels and each having a first end portion on a light incident side and a second end portion on a side opposite to the first end portion;
   a first member disposed along a boundary of each of the multiple photoelectric conversion sections in a first direction that extends from the first end portion to the second end portion; and
   a second member provided between each of the multiple photoelectric conversion sections and the first member and on a side of the first end portion, the second member containing a material with a lower refractive index than that of the photoelectric conversion sections.
(2) The imaging device according to (1), in which the second member includes a conductor.
(3) The imaging device according to (1), in which the second member includes sealed air.
(4) The imaging device according to (1), in which a thickness of the second member decreases along the first direction.
(5) The imaging device according to (1), further including:
   in a region other than a region in which the second member is disposed in each of the photoelectric conversion sections, a semiconductor layer of a different conductivity type from that of the photoelectric conversion sections.
(6) The imaging device according to (1), in which
   the second member extends along the first direction to a side of the second end portion, and
   a sum of a thickness of the first member and a thickness of the second member is constant along the first direction.
(7) The imaging device according to (6), in which a thickness on the side of the first end portion of the second member is smaller than a thickness on the side of the second end portion thereof.
(8) The imaging device according to (1), in which
   the multiple photoelectric conversion sections each have a first portion and a second portion, and,
   in plan view, the first portion and the second portion are surrounded by the first member at a boundary therebetween, except for certain portions of central portions of the first portion and the second portion, and are in contact with each other at the certain portions.
(9) The imaging device according to Claim 1, in which
   the multiple photoelectric conversion sections each have a substantially rectangular shape in plan view, and
   a thickness at a corner portion of the substantially rectangular shape of the second member is larger than a thickness at another portion thereof.
(10) The imaging device according to any one of (1) to (9), in which
   a thickness of the second member is 20 nm or more, and
   a length in a depth direction of the second member is 1,000 nm or more.
(11) The imaging device according to any one of (1) to (10), in which the second member is disposed to surround each of the multiple photoelectric conversion sections.
(12) The imaging device according to any one of (1) to (11), in which the first member contains polysilicon.
(13) The imaging device according to any one of (1) to (12), further including:
   a micro lens provided correspondingly to each of the multiple photoelectric conversion sections.
(14) The imaging device according to (13), further including:
   a color filter provided between each of the multiple photoelectric conversion sections and the micro lens.
(15) The imaging device according to any one of (1) to (12), in which
   the multiple photoelectric conversion sections are divided into groups arranged in an array, and
   the imaging device further includes a micro lens provided correspondingly to each of the groups.
(16) The imaging device according to any one of (1) to (15), further including:
   a circuit disposed on a side of the second end portion and including a pixel transistor.
(17) The imaging device according to any one of (1) to (16), in which
   the multiple photoelectric conversion sections each contain silicon, and
   the second member contains silicon oxide.
(18) An electronic apparatus including:
   an imaging device; and
   a signal processing unit configured to perform signal processing based on a pixel signal captured by the imaging device,
   the imaging device including
      multiple photoelectric conversion sections provided for respective pixels and each having a first end portion on a light incident side and a second end portion on a side opposite to the first end portion,
      a first member disposed along a boundary of each of the multiple photoelectric conversion sections in a first direction that extends from the first end portion to the second end portion, and
      a second member provided between each of the multiple photoelectric conversion sections and the first member and on a side of the first end portion, the second member containing a material with a lower refractive index than that of the photoelectric conversion sections.

### [Reference Signs List]

10a, 10b, 10c, 10d: Pixel
12: Photoelectric conversion layer
12a, 12b, 12c, 12d: Photoelectric conversion section
13: Trench
14: Conductor
15, 15a, 15c, 15d: Light absorption inhibition section
16: Inter-pixel light shielding section
17a, 17b: Color filter
18: Micro lens
20: Circuit
22: Stacked wiring section
24: Second stage section
26: First stage section
30: Silicon oxide
32: Polycrystalline silicon
34: Fixed charge film
36: Oxide film
38: Uneven structure
39: Low refractive index waveguide
400: Mask
402: Region
410: Silicon oxide
420: Fixed charge film
430: Oxide film
7000: Vehicle control system
7010: Communication network
7100: Driving system control unit
7110: Vehicle state detecting section
7200: Body system control unit
7300: Battery control unit
7310: Secondary battery
7400: Outside-vehicle information detecting unit
7410: Imaging section
7420: Outside-vehicle information detecting section
7500: In-vehicle information detecting unit
7510: Driver state detecting section
7600: Integrated control unit
7610: Microcomputer
7620: General-purpose communication I/F
7630: Dedicated communication I/F
7640: Positioning section
7650: Beacon receiving section
7660: In-vehicle device I/F
7670: Sound/image output section
7680: Vehicle-mounted network I/F
7690: Storage section
7710: Audio speaker
7720: Display section
7730: Instrument panel
7750: External environment
7760: In-vehicle device
7800: Input section
7900: Vehicle
7910 to 7916: Imaging section
7920 to 7930: Outside-vehicle information detecting section

## Claims

1. An imaging device comprising:
multiple photoelectric conversion sections provided for respective pixels and each having a first end portion on a light incident side and a second end portion on a side opposite to the first end portion;
a first member disposed along a boundary of each of the multiple photoelectric conversion sections in a first direction that extends from the first end portion to the second end portion; and
a second member provided between each of the multiple photoelectric conversion sections and the first member and on a side of the first end portion, the second member containing a material with a lower refractive index than that of the photoelectric conversion sections.

2. The imaging device according to claim 1, wherein the second member includes a conductor.

3. The imaging device according to claim 1, wherein the second member includes sealed air.

4. The imaging device according to claim 1, wherein a thickness of the second member decreases along the first direction.

5. The imaging device according to claim 1, further comprising:
in a region other than a region in which the second member is disposed in each of the photoelectric conversion sections, a semiconductor layer of a different conductivity type from that of the photoelectric conversion sections.

6. The imaging device according to claim 1, wherein
the second member extends along the first direction to a side of the second end portion, and
a sum of a thickness of the first member and a thickness of the second member is constant along the first direction.

7. The imaging device according to claim 6, wherein a thickness on the side of the first end portion of the second member is smaller than a thickness on the side of the second end portion thereof.

8. The imaging device according to claim 1, wherein
the multiple photoelectric conversion sections each have a first portion and a second portion, and,
in plan view, the first portion and the second portion are surrounded by the first member at a boundary therebetween, except for certain portions of central portions of the first portion and the second portion, and are in contact with each other at the certain portions.

9. The imaging device according to claim 1, wherein
the multiple photoelectric conversion sections each have a substantially rectangular shape in plan view, and
a thickness at a corner portion of the substantially rectangular shape of the second member is larger than a thickness at another portion thereof.

10. The imaging device according to claim 1, wherein
a thickness of the second member is 20 nm or more, and
a length in a depth direction of the second member is 1,000 nm or more.

11. The imaging device according to claim 1, wherein the second member is disposed to surround each of the multiple photoelectric conversion sections.

12. The imaging device according to claim 1, wherein the first member contains polysilicon.

13. The imaging device according to claim 1, further comprising:
a micro lens provided correspondingly to each of the multiple photoelectric conversion sections.

14. The imaging device according to claim 13, further comprising:
a color filter provided between each of the multiple photoelectric conversion sections and the micro lens.

15. The imaging device according to claim 1, wherein
the multiple photoelectric conversion sections are divided into groups arranged in an array, and
the imaging device further includes a micro lens provided correspondingly to each of the groups.

16. The imaging device according to claim 1, further comprising:
a circuit disposed on a side of the second end portion and including a pixel transistor.

17. The imaging device according to claim 1, wherein
the multiple photoelectric conversion sections each contain silicon, and
the second member contains silicon oxide.

18. An electronic apparatus comprising:
an imaging device; and
a signal processing unit configured to perform signal processing based on a pixel signal captured by the imaging device,
the imaging device including
multiple photoelectric conversion sections provided for respective pixels and each having a first end portion on a light incident side and a second end portion on a side opposite to the first end portion,
a first member disposed along a boundary of each of the multiple photoelectric conversion sections in a first direction that extends from the first end portion to the second end portion, and
a second member provided between each of the multiple photoelectric conversion sections and the first member and on a side of the first end portion, the second member containing a material with a lower refractive index than that of the photoelectric conversion sections.
